# EUROPEAN PATENT SPECIFICATION

(11) **EP 4 651 190 B1**
(45) Date of publication and mention of the grant of the patent: **08.07.2026**
(21) Application number: 24176258.2
(22) Date of filing: 16.05.2024
(51) Int. Cl.: H10P 72/00, H10P 74/00, H10P 74/20

(54) **METHOD FOR CONTROLLING A WET ETCHING PROCESS**
VERFAHREN ZUR STEUERUNG EINES NASSÄTZPROZESSES
PROCÉDÉ DE COMMANDE D'UN PROCESSUS DE GRAVURE HUMIDE

(43) Date of publication of application: 19.11.2025
(73) Proprietor: Nexgen Wafer Systems Pte. Ltd., 569880, Singapore (SG)
(72) Inventor: KLEINDIENST, Christian, 598679 Singapur (SG); SANDRIESSER, Josef, 9710 Feistritz an der Drau (AT); ROS GONZALEZ, Dante, 9500 Villach (AT); ABABA DECIERDO, Gregorio Jr., 9500 Villach (AT); HUBER, Martin, 9500 Villach (AT); IBRAHIM, Hazem, 9020 Klagenfurt (AT)
(74) Representative: Maiwald GmbH

(56) References cited:
- WO-A1-2023/106084
- US-A1- 2021 202 258

## Description

### TECHNICAL FIELD

The present invention generally relates to the field of wet etching processing of specimens, in particular semiconductor wafers. The present invention specifically relates to a method for controlling a wet etching process, a computer program product, a data processing system, and a system for carrying out a wet etching process.

### BACKGROUND

Wet etching is an etching process that takes off material from a specimen or, in other words, substrate material from a substrate by using a chemical liquid or, in other words, a liquid chemical, which may comprise one or more chemical etchants. The specimen, typically a semiconductor wafer, is immersed in the chemical liquid, or the chemical liquid is dispensed onto the wafer, which etches a wafer surface during the process. For semiconductor wafers as specimens, this process is often being used typically for or within wafer thickness reduction, in particular on a backside of the wafer as opposed to a frontside of the wafer. A result of the wet chemistry etching may be that the surface roughness of the specimen surface is changed, in particular in a controlled manner such that it is within a target or target range of surface roughness.

The wet etching may be carried out during the backend-of-the-line (BEOL) stage of the semiconductor manufacturing process. In an exemplary BEOL process for power semiconductor devices employing the wafer, the wet etching may be used for wet chemical surface finishing of the wafers. Typically, tape bonding or using a glass carrier wafer and wafer back grinding are preceding the wet etching. Contact formation, annealing and back side metallization may follow the wet etching during the typical BEOL process of semiconductor manufacturing.

A challenge in wet etching of specimens, even for specimens of the same batch, is that each specimen may be different with respect to its total thickness variation prior to the wet etching process. The total thickness variation (TTV) reflects the overall uniformity or non-uniformity of a specimen surface of the specimen and may be affected in the specimens prior to the wet etching process by several factors, including but not limited to environmental exposure, e.g., temperature and humidity, and any of the previous processes carried out on the specimen during the BEOL process. Given the different TTVs of the specimens, it has been found that when every single specimen is processed in the same way, i.e., with the same settings of the wet etching process, e.g., the dispensing time of the chemical liquid onto the specimen surface, it may be difficult to produce a TTV of each specimen after the wet etching process, which is within an accepted quality range.

Hence, it would be desirable to perform the wet etching process of specimens with a certain quality, i.e., with a TTV within an accepted quality range, and/or a constant quality, i.e., a TTV of specimens of the same and different batches after wet etching being substantially constant and/or within the accepted quality range. Such wet etching processing should not introduce any new potential quality related issues with respect to the wet etching of specimens.

US 2021/202258 A1 describes a substrate treatment apparatus includes a nozzle, a moving mechanism, a storage portion, and a control portion. A learned model is generated by learning, as learning data, learning target speed information indicating a moving speed of the nozzle and the amount of treatment acquired by executing a treatment on a substrate that is a learning target while causing the nozzle to move at a speed based on the learning target speed information. The control portion causes speed information at the time of treatment to be outputted from the learned model by inputting a target amount of an amount of treatment to the learned model. The control portion controls a moving mechanism such that the nozzle moves at a speed based on the speed information at the time of treatment when the treatment is executed on a substrate that is a treatment target.

WO 2023/106084 A1 describes a method according to the preamble of claim 1.

### SUMMARY OF THE INVENTION

The above problem is at least partially solved or alleviated by the subject matters of the independent claims of the present disclosure, wherein further examples are incorporated in the dependent claims. The invention is defined in the independent claims.

According to a first aspect of the present invention, there is provided a method for controlling a wet etching process as recited in claim 1. **The** method of this disclosure in particular provides for controlling each wet etching process of single specimens by controlling one or more settings of the wet etching process for this single specimen based on a thickness profile of a thickness variation of the single specimen. Thereby, the one or more settings of the wet etching process may be controlled individually for every single specimen based on the individual thickness profile thereof. Thereby, the method does not rely on fixed settings for every specimen, of a batch or for different batches, to perform the wet etching process of the specimens, but may provide individual settings for each specimen based on the obtained thickness profile data. By considering the individual thickness profile of the thickness variation of the specimen, the settings may be controlled according to a required quality, e.g., the TTV of each wet etched specimen may be kept in an accepted quality range of TTV.

While the one or more settings of the wet etching process may be controlled based on the control data by the method, advantageously, no potential quality related issues with respect to the wet etching of the individual specimens are introduced. This is in particular avoided by the continuous movement of the dispensing unit along the dispensing trajectory relative to the specimen while the chemical liquid is being dispensed onto the specimen surface and while rotating the specimen by the rotation unit. Specifically, it has been found that when a discrete or discontinuous movement of the dispensing unit to distinct positions relative to the specimen while the chemical liquid is being dispensed may cause quality related issues. Such discrete or discontinuous movement is opposite or contrary to the herein suggested continuous movement along the dispensing trajectory while dispensing and rotating the specimen. Further, the dispensing time may be very long at certain radial positions. In any case, such discrete or discontinuous movement may cause the specimen to run dry at areas which are not covered with the chemical liquid during dispensing at the distinct positions. This can lead to residues and undesired optical and structural effects on the specimen surface. Further, this may cause discontinuous height differences on the specimen surface and steps in the thickness profile or variation of the wafer, which may be a source for other undesired effects in the further processing of the wafers as well as in the yield of the overall processing and reliability of the final devices using the specimens.

With the continuous movement along a dispensing trajectory during the dispensing, on the other hand, such quality related issues may be omitted. Specifically, by continuously moving the dispensing unit along the dispensing trajectory during the dispensing, a drying out of areas of the specimen surface and step formation or discontinuous height differences on the specimens may be avoided, while the controlling of the one or more settings of the wet etching process based on the thickness profile data may be advantageously carried out.

The continuous movement along the dispensing trajectory may be at least partially continuous along the trajectory, e.g., for at least 5%, 10%, 20%, 50% or more of the length of the dispensing trajectory, e.g., substantially the entire dispensing trajectory. In other words, it may not be necessary but advantageous to provide a continuous movement along substantially or approximately the entire dispensing trajectory. Hence, the continuous movement may be between two or more points on the dispensing trajectory, for example. For example, the continuous movement may be a linear movement. The continuous movement may not involve any stops or, in other words, be uninterrupted. However, the continuous movement may involve that different amounts of chemical liquid are dispensed at different points along the dispensing trajectory or, alternative, that the chemical liquid is dispensed uniformly along the dispensing trajectory, depending on the control data. The continuous movement may be analogue, which may mean that the dispensing unit is never stopping along the dispensing trajectory.

The wet etching process may be a single specimen etching process, in which single specimens may be consecutively etched by dispensing the chemical liquid onto the specimen surfaces of the single specimens. For example, the chemical liquid may be dispensed, e.g., dropped, sprayed or similar, by a nozzle, spraying system or similar dispensing unit of the wet etching processing system onto the specimen surface of the specimen, in particular a side, more particularly a backside, of a wafer. The specimen may be rotated by the rotation unit during the dispensing of the chemical liquid or wet etching process for better distribution of the chemical liquid on its surface. An opposing surface may not be needed or must not be subjected to the chemical liquid, in which case a gas stream, e.g., air stream, or similar may be supplied to or at that side, preventing that the chemical liquid reaches that side, in particular the frontside and/or backside of the wafer. The single specimen etching process may be performed by a type of wet etching processing system, which may be referred to as a single specimen wet etching processing system. Only one specimen at a time may be etched, at least within one processing chamber or device for etching, as opposed to when multiple specimens are etched, e.g., by means of batch etching, in which multiple specimens may be placed into a carrier and dipped into a bath of chemical liquid. However, there may be multiple processing chambers or devices, in which case in every one of these a specimen may be etched at least partially in parallel.

The method of the first aspect may in particular be an at least partially or fully computer implemented method. This means that at least one, multiple or all of the steps of the method may be carried out by a data processing system, which may comprise one or more data processing apparatuses, e.g., computers or computing units, which may be part of a system for performing the wet etching process or, in other words, wet etching processing system. Different steps may be carried out by the same or by different computers. A computer is herein understood as a data processing apparatus, which can carry out some, multiple or all steps as defined by the method. The one or more computers may be configured as or provided inside of one or more sensor units, control units and/or other units of the wet etching processing system or separate therefrom but as part of the wet etching processing system. These sensor units, control units and/or other units may also be configured to carry out other control operations than described by the method according to this disclosure.

The obtaining of the thickness profile data may be based on a measurement or measurement data indicative of the thickness variation along the measurement line on the specimen. Optionally, the obtaining of the thickness profile data may comprise determining the thickness profile based on the measurement. Moreover, the control data may be obtained by determining the one or more settings based on the obtained or determined thickness profile. Hence, the thickness profile data may not be the measurement data as such but be determined based on it. Alternatively, the thickness profile data may be the measurement data as such, e.g., when the sensor or measurement unit providing the measurement or measurement data may directly obtain the thickness profile data rather than, e.g., images or other measurements of the specimen surface, from which the data processing apparatus first needs to determine the thickness profile data. Moreover, the method may comprise executing the control data during or for the wet etching process of the specimen. Thereby, the control data may be used to achieve the advantages explained herein with having one or more settings of the wet etching process that are individually obtained or determined based on the thickness profile of the specimen being etched.

The obtaining of the thickness profile data may be performed by the data processing system, for example. Alternatively, or additionally, the obtaining of the thickness profile data may be performed by one or more sensor or measurement units of the wet etching processing system, which may include one or more spectrometers, e.g., FTIR (Fourier-transform infrared spectroscopy) spectrometers, cameras and/or scanners, which may send the thickness profile data or measurement data to the data processing system, where the thickness profile data may be determined based on the measurement data. In the additional variant of the aforesaid, the one or more sensor or measurement units may provide the measurement data and/or the thickness profile data to the data processing system to be obtained by it. Alternatively, or additionally, the method may, in addition to obtaining the measurement data or the thickness profile data, comprise measurement of the measurement data, e.g., by the one or more sensor or measurement units of the wet etching processing system. The measurement may be based on obtaining interferograms, images, and/ or line scanning along the measurement line, for example. The measurement line does not necessarily need to be a line measured by the sensor or measurement units, but the sensor or measurement units may measure more than just the line, e.g., the entire specimen surface. However, the measurement line may also be the measurement line used by the sensor or measurement unit, e.g., of the measurement beam of a spectrometer, such as a FTIR spectrometer. In any case, the thickness variation of the specimen is considered only along the measurement line for establishing the thickness profile and based on that determining the thickness profile data. Specifically, when the specimen is round or disc-like shaped, the measurement line may be congruent or coincide with a diameter of the specimen, thus giving a very good indication of the total thickness variation throughout the specimen along the diameter. However, the measurement line may alternatively be shifted from the diameter of the specimen.

The obtaining of the control data may be performed by the data processing system, for example. Alternatively, or additionally, the obtaining of the control data may be performed by one or more control units and/or one more operational units configured to carry out the one or more control settings, the unit(s) being of the wet etching processing system. In the additional variant of the aforesaid, the data processing system may provide the control data to the one or more control units and/or one or more operational units to be obtained by it or them, and to be carried out consequently. For example, the one or more control and/or operational units may be configured for performing the one or more settings of the control data during the etching duration of the specimen. For example, the operational units may be or comprise any of, but not limited to, the dispensing unit the rotation unit, a pump fluidically connected to the dispensing unit and a container, a feed line into the container of the wet etching processing system, the container containing the chemical liquid, and similar.

Alternatively, or additionally, the method of this disclosure may, in addition to obtaining the control data, comprise carrying out the control data, i.e., the one or more settings to be controlled, e.g., by the one or more control units and/or the one or more operational units of the wet etching processing system. The obtaining of the control data may be a determining of the control data, in particular by the data processing system.

As discussed herein, the thickness profile data may be based on a measurement along the measurement line on the specimen surface or a determination of the thickness variation along the measurement line, in which case it may also be referred to as a determination line or similar, along which the thickness variation is being determined for establishing the thickness profile of the specimen. In case the specimen has a round or disc-like shape, the measurement line may be congruent or coincide with the diameter of the specimen surface. For the measurement along the measurement line, a spectrometer, e.g., FTIR spectrometer, line scanner and/or camera or similar measurement unit may be used.

Generally, the thickness variation may be a thickness measured at multiple points or positions of the specimen surface. For example, the thickness may be measured by means of the one or more sensor or measurement units. In particular, the thickness may be a thickness variation or total thickness variation of at least a section or substantially the entire specimen or surface thereof, which may reflect the overall uniformity or non-uniformity of a surface of the specimen, in particular of the backside of a semiconductor wafer. Specifically, the thickness variation along the measurement line may be continuous, quasi-continuous or discrete, i.e., single values or points of thickness, for each measurement point or determination point along the measurement line. The thickness variation exists due to the variation of the thickness values between the points along the measurement line. Hence, the thickness profile may be indicative of a large number of single values of thickness along the measurement line. The total thickness variation on the other hand side may be a single value representing all thickness values along the measurement line of the thickness profile. For example, the TTV may be an arithmetic mean of all thickness values along the measurement line of the thickness profile.

Herein, the controlling of the one or more settings may for example mean that one or more settings are determined or set. Alternatively, or additionally, for example, the controlling of the one or more settings may mean adjusting current or currently set settings by adjusting them. Further examples of control of settings are given below and the control in the examples of the determination or setting and adjustment as described may mutually apply to these settings.

The specimen may for example be a wafer, in particular a semiconductor wafer. A semiconductor wafer may be used to fabricate integrated circuits. In particular, the wafer may be etched at its backside opposing its frontside, where any of the sides may be used for power supply of the wafer and forming a power semiconductor device. The wafer may comprise Silicon, in particular crystalline Silicon, or any other semiconductor material such as but not limited to Germanium, Gallium arsenide, Indium phosphide, Silicon carbide, Gallium nitride or Sapphire. The specimen may be of any size and geometry. The specimen may for example be disc-shaped. The specimen may alternatively be referred to as a substrate, in particular a disc-shaped substrate. The specimen may alternatively be any other substrate than a wafer, e.g., a metal substrate or glass substrate.

The chemical liquid may be continuously dispensed by the dispensing unit onto the specimen surface while the dispensing unit may be continuously moved along the dispensing trajectory relative to the specimen. Hence, while the continuous movement of the dispensing unit, also the dispensing unit may be continuously operated in that it continuously dispenses the chemical liquid. This means that during the entire continuous movement of the dispensing unit, e.g., along a part of a length or the entire length of the dispensing trajectory, the chemical liquid is continuously dispensed. The dispensing amount during the continuous dispensing may vary along the dispensing trajectory or, alternatively, be uniform along the dispensing trajectory.

According to the invention, the dispensing trajectory is congruent to the measurement line. In other words, the dispensing trajectory may follow the measurement line. Hence, the dispensing trajectory may be aligned optimally with the thickness variation along the measurement line such that that the thickness variation along the measurement line may be reduced. In particular, in case of a round or disc-like shaped specimen, due to the rotation during dispensing, having the dispensing trajectory congruent with the measurement line and diameter, allows to reach all of the areas of the specimen surface with chemical liquid by the continuous movement of the dispensing unit and/or continuous dispensing of the dispensing unit, thereby preventing that any area of the specimen surface is not reached by the chemical liquid and/or dries out.

Also the dispensing trajectory and/or the measurement line may be traversing a center of the specimen surface. In particular, the dispensing trajectory and/or the measurement line may be traversing a center of the specimen surface independent of the shape of the specimen but in particular in the case of a round or disc-like shape of the specimen, in which case also its diameter may be traversing the center of the specimen surface.

At least one of the one or more settings may relate to one or more of:
a dispensing time for dispensing the chemical liquid by the dispensing unit,
a dispensing flow rate of chemical liquid out of the dispensing unit,
a dispensing profile for dispensing the chemical liquid by the dispensing unit, the dispensing profile being indicative of a dispensing time and/or dispensing flow rate along the dispensing trajectory,
a rotation speed of the rotation unit,
a temperature of the chemical liquid,
a selection of a chemical liquid from different chemical liquids contained in different containers,
a change of composition of the chemical liquid used by the dispensing unit,
a pressure of a gas stream around at least parts of the specimen, and
a selection of one or more dispensing ports from two or more dispensing ports of the dispensing unit.

In particular, in the case of multiple settings, e.g., two or more, each one of these settings may relate to any different one of the aforementioned. For example, the dispensing time may be a total dispensing time of the dispensing unit during the continuous movement and/or continuous dispensing or the dispensing time per parts or lengths of the dispensing trajectory or the full dispensing trajectory. Or, generally, the dispensing time may be a dispensing time per area of the specimen surface, for example. The dispensing time has a significant influence on the etching of the specimen surface because, generally, the specimen surface is etched more with increased dispensing time. Similarly, the specimen surface is etched more with increased dispensing flow rate. The dispensing flow rate of the chemical liquid out of the dispensing unit may be the flow rate of the chemical liquid coming out of the dispensing unit, in particular one or more dispensing ports thereof, which are thus dispensed onto the specimen surface. The dispensing profile may describe the dispensing time and/or dispensing flow rate along or per parts or lengths of the dispensing trajectory. The rotation speed of the rotation unit, e.g., as may be indicated in rotations per minute, may influence the distribution of the dispensed chemical liquid on the specimen surface. The temperature of the chemical liquid may also have an influence on the etching, e.g., because a comparatively colder chemical liquid may have different etching properties as a comparatively hotter, which may for example include the distribution of chemical liquid on the specimen surface. Moreover, different containers may be provided with different chemical liquids. Different chemical liquids may be different in their composition, e.g., use different etchants and/or different amounts of the same etchant. Hence, for each specimen, depending on the profile thickness data, a different chemical liquid may be provided through the dispensing unit onto the specimen surface, which may be better fitting for etching the particular thickness profile of that specimen in a uniform manner. Further, the composition of the dispensed chemical liquid itself may be changed, for example by buffering or spiking the chemical liquid with an etchant. Moreover, it may be possible to adjust a pressure of a gas stream around at least parts of the specimen. Specifically, an opposing surface opposite of the etched specimen surface may not be needed or must not be subjected to the chemical liquid, in which case a gas stream, e.g., air stream, may be provided preventing that the chemical liquid reaches the opposing surface. Alternatively, or additionally, such gas stream may be provided to remove or suck off any potentially harmful gas or steam being produced by the wet etching process. That gas stream may also flow around or near the chemical liquid dispensed onto the specimen surface. By adjusting the pressure, the influence of the gas stream on the etching process may be adapted, which may for example cause an area of the specimen surface to dry out slower or faster depending on the pressure. Moreover, one or more dispensing ports out of two or more dispensing ports may be selected for the dispensing of the chemical liquid. Thereby, the location of the dispensing may further be influenced, in particular along the dispensing trajectory, but for example with some offset therefrom depending on the selected dispensing port. In particular, the dispensing unit may be a dispenser having two or more dispensing ports or, in other words, outlets or orifices, through which the chemical liquid may be dispensed or, in other words, ejected onto the specimen surface. For example, the dispensing unit may comprise one or more nozzles. In particular, the dispensing unit may comprise a multi-nozzle with two or more dispensing ports or, in other words, nozzle outlets in the case of a nozzle. The different nozzles or dispensing ports may be fluidically connected to different containers containing different or the same chemical liquid composition or connected to the same container. Moreover, the dispensing unit may also comprise separate nozzles or dispensers. At least one, multiple or all of these separate nozzles or dispensers may be moveable separately. At least one, multiple or all of these separate nozzles or dispensers may be continuously moved along the dispensing trajectory, wherein the nozzles or dispensers may be moving on different parts of the dispensing trajectory simultaneously.

The obtaining of the control data may comprise:
- classifying a shape and/or one or more shape characteristics of the thickness profile into one of multiple different shapes and/or multiple different shape characteristics of thickness variation, each one of the multiple different shapes and/or multiple different shape characteristics of thickness variation being correlated with one or more settings for a wet etching process of the specimen,
- determining the one or more settings based on the classified shape and/or classified one or more shape characteristics.

Generally, the classification may be an autoclassification, such that the classification occurs in an automated manner. The classification may alternatively be referred to as a detection of a type or class of the respective shape and/or one or more shape characteristics. The multiple different shapes may be predefined. The shape of the thickness profile may be the shape of thickness variation over the measurement line. That is, when one views a graph of the thickness over the measurement line, the variation of the thickness over the measurement line as seen in the graph is or resembles the shape. The predefinition may be based on typically experienced different shapes, where the different shapes may be approximate in their shape, i.e., the classified shape does not need to exactly match the one of the multiple different, in particular predefined, shapes. For example, as later explained herein, the multiple different shapes may be generally or broadly categorized into different characters or symbols, such as multiple letters, for example, which are often experienced to resemble the shape of the thickness profile. In addition, or as alternative, the classification of one or more shape characteristics may be carried out for the thickness profile. Shape characteristics may be present in parts of the shape. They may be for example but not only the height of peaks or local maxima or absolute maxima and/or of valleys or local minima or absolute minima in the shape or thickness profile, the position of peaks and/or valleys, the slopes between peaks and valleys, and similar. Hence, an even finer classification of the thickness profile may be possible when classifying its one or more shape characteristics, in particular multiple shape characteristics, into different shape characteristics, which may be predefined similar as described herein with respect to the predefinition of the shapes. The in particular predefined shapes and/or multiple different shape characteristics are correlated with one or more settings, in particular different settings, for the wet etching process. This correlation may be stored on a data storage medium, which the method may access in order to obtain, in particular determine, the control data. The correlation may for example be based on calculations, experience, i.e., previous measurements of different specimens, and/or the herein mentioned machine learning algorithm. In particular, based on experience, calculation and/or the machine learning algorithm, it may be known which specific settings are advantageous to produce a high-quality specimen surface, in particular one with a small TTV within a specified quality range, based on the classified shape of its thickness profile and/or the shape characteristics. Accordingly, the one or more settings may be determined based on the classified shape and/or classified one or more shape characteristics and on the thereto correlating one or more settings such that the control data for controlling these one or more settings may be obtained.

The determined one or more settings or generally, the one or more settings in the control data, may be obtained, e.g., selected, from predefined one or more settings, e.g., sets of settings, defining any one or more of the previously mentioned, or may be determined in each case individually. That means, for example, that for each predefined shape and/or shape characteristics, there may be predefined one or more settings or sets of settings, which may be obtained or determined, e.g., by selection, according to the shape and/or shape characteristics of the thickness profile of a given, in particular measured, specimen classified into the predefined shape and/or shape characteristics. Alternatively, or additionally at least parts of the one or more settings, the one or more settings may be individually determined for that very shape and/or shape characteristics of the thickness profile of that very specimen in that one or more of the settings may be individually calculated and not taken from predefined one or more settings or sets of settings. Generally, predefined one or more settings or sets of settings may be herein also referred to as a predefined recipe with predefined parameters, which are reflecting the one or more settings. For example, a predefined recipe may be one with a recipe parameter of a certain dispensing flow rate and a certain rotation speed. Similarly, an individually determined recipe for a specimen may be obtained by individually determining the respective recipe parameters, e.g., dispensing flow rate and rotation speed.

The method may comprise classifying the shape of the thickness profile first and consequently classifying the one or more shape characteristics for the classified shape into one of multiple shape characteristics for the classified shape. This way, an even more accurate classification may be provided, which in the end results in the obtaining of one or more settings, which are a good fit for the shape and the one or more shape characteristics of the thickness profile of the given specimen. That is, the classifying of the shape of the thickness profile may be a coarse classification, after which a finer classification into the one or more shape characteristics may follow. The one or more shape characteristics may be specifically provided for the classified shape. For example, each classified shape may have its own, in particular predefined, multiple different shape characteristics and/or these may be correlated to different settings. Hence, a finer classification may benefit from the one or more shape characteristics and/or the settings correlated therewith being specific for the classified shape.

The shape of the thickness profile may be classified into a shape of at least four different shape types. The at least four different shape types may be comprising a substantially A-shaped type, a substantially V-shaped type, a substantially W-shaped type, and a substantially M-shaped type. These four different shapes or shape types are exemplary and non-limiting, but they are exemplary for what have been identified among the most commonly present shapes or shape types by measurement. Hence, it may be advantageous to classify into at least any of these four shapes and provide settings correlated therewith.

The classification may be carried out at least partially or substantially in full by a machine learning algorithm. The machine learning algorithm may be carried out by the data processing system. The machine learning may in particular provide an autoclassification of shapes and/or one or more shape characteristics and thus deliver fast and accurate results. Also, the machine learning may adapt the settings correlated with the different shapes and/or different shape characteristics. Further, the machine learning algorithm may learn the shapes and shape characteristics and improve the classification over time, e.g., finding more predefined shapes and/or shape characteristics. As input data or training data for the machine learning algorithm, the thickness profile data, the measurement data and/or the control data may be provided. Any of these data may be from a current controlling of a wet etching process or a previous one. Also, if shapes and/or one or more characteristics as well as one or more settings correlated thereto are manually set up, these may be provided to the machine learning algorithm as additional input for starting the machine learning algorithm. Then, the correlated settings may be adapted based on machine learning. Generally, the machine learning algorithm may employ any technique such as but not limited to deep learning, neural networks, etc.

The machine learning algorithm may be trained with the one or more settings of the control data from previous wet etching processes and/or measurement data indicative of measured thickness variations along the measurement line of specimens etched by the previous wet etching processes. Hence, the machine learning algorithm may consistently improve the determination of the one or more settings based on the shape and/or shape characteristics by finding new or better correlations of settings to the predefined shapes and/or shape characteristics, which may also be predefined finer, e.g., by adding new predefined shapes and/or shape characteristics, splitting these up, deleting previous ones, and similarly. Specifically, by giving the machine learning algorithm training data in form of the control data, i.e., the one or more settings that have been applied and the measurement data after the one or more settings have been applied, in particular in addition to the thickness profile data, the machine learning algorithm may learn the effect these settings had on a particular shape and/or one or more shape characteristics and adjust the settings for similar or same shapes and/or shape characteristics, for example, through the processing of the next or future specimens, thereby improving the wet etching process consistently for reaching TTV within a controlled narrow quality range of TTV.

According to a second aspect of this disclosure, there is provided a computer program product comprising instructions which, when the program is executed by a computer or data processing apparatus, cause the computer or data processing apparatus to carry out the method according to the first aspect of this disclosure.

The computer program product may be a computer program, in particular as such, meaning a computer program consisting of or comprising a program code to be executed by the computer or data processing apparatus. Alternatively, the computer program product may be a product such as a data storage, in particular a computer-readable data storage medium, on which the computer program may be at least temporarily or permanently stored.

According to a third aspect of this disclosure, there is provided a data processing system configured to carry out the method according to the first aspect of this disclosure.

The data processing system may comprise one or more computers or data processing apparatuses as previously described and, optionally, the computer program product of the second aspect of this disclosure.

According to a fourth aspect of this disclosure, there is provided a system for carrying out a wet etching process, the system comprising the data processing system of the third aspect of this disclosure, a container for containing the chemical liquid, the dispensing unit fluidically connected to the container for dispensing the chemical liquid from the container onto the specimen surface, and the rotation unit for rotating the specimen.

Further, the system may comprise a measurement system for obtaining the measurement data as mentioned herein. As previously mentioned, the measurement system may comprise one or more sensor or camera units for obtaining the measurement data, from which the thickness profile data may be obtained, in particular determined, and/or for directly obtaining the thickness profile data. The sensor or measurement unit(s) may be any of a spectrometer, e.g., FTIR spectrometer, line scanner, camera, and/or similar, for example. Further, the system or, in other words, wet etching processing system may comprise a chamber or device for containing the specimen during the dispensing of the chemical liquid onto the specimen surface. The rotation unit may be provided in the wet etching processing system for rotating the specimen during the dispensing of the chemical liquid. Further, the wet etching processing system may comprise a feed line, pump and/or similar fluidically connecting the dispensing unit or, in other words, dispenser with the container. Similarly, a drain line, pump and/or similar may be provided in the wet etching processing system to fluidically connect a drain section of the chamber or device with the container to allow drainage of the chemical liquid used for etching the specimen in the chamber or device therefrom and recirculation to the container.

If two or more different wet etching processes are being used simultaneously, the wet etching processing system may comprise two or more container for each one of the different chemical liquid. Also, generally, the system may comprise two or more containers, for example, each one containing a different chemical liquid composition, wherein a setting in the control data may be to select any one of the different chemical liquid compositions based on the thickness profile data. Further, the wet etching processing system may comprise separate chambers or drain sections inside one chamber or device for draining and recirculating each one of the different chemical liquids separately to their respective container. Also, the wet etching processing system may comprise an actuator for moving the specimen between the at least two chambers or drain sections, e.g., which may also be rotatable or rotatably connected to the rotation unit, for example, e.g., in the form of a linearly moveable axis to move the specimen between the two chambers or drain sections.

It is noted that the above aspects, examples and features may be combined with each other irrespective of the aspect involved.

The above and other aspects of the present disclosure will become apparent from and elucidated with reference to the drawings described hereinafter.

### BRIEF DESCRIPTION OF THE DRAWINGS

Exemplary embodiments will be further described with reference to Figures, wherein:
Figure 1 shows a perspective view of a wet etching processing system according to an example.
Figure 2 shows a schematic illustration of the wet etching processing system of Fig. 1 with its components.
Figure 3 shows a perspective view of a processing chamber of the wet etching processing system of Figs. 1 and 2 while etching a wafer.
Figure 4 shows a schematic illustration of a BEOL process of a semiconductor manufacturing process.
Figure 5 shows schematic illustrations of the typical thickness variation for a wafer, from wafer to wafer, from batch to batch before chemical surface finishing, und a schematic illustration of the thickness variation for batch to batch if processed according to the method of Fig. 7.
Figure 6 shows two graphs of thickness variation for a wafer, the left one being based on a measurement before the wet etching and the second one being based on a measurement after the wet etching according to the method of Fig. 7.
Figure 7 shows a schematic illustration of a method for carrying out any one of the wet etching processes of Fig. 4.
Figure 8 shows a cross-sectional schematic illustration through the dispensing unit and wafer inside the processing chamber of Fig. 3.
Figure 9 shows four graphs of different thickness profiles of wafers as may be classified by the method of Fig. 7.

The Figures are schematic only and not true to scale. In principle, identical or like parts, elements and/or steps are provided with identical or like reference numerals in the Figures.

### DETAILED DESCRIPTION OF THE INVENTION

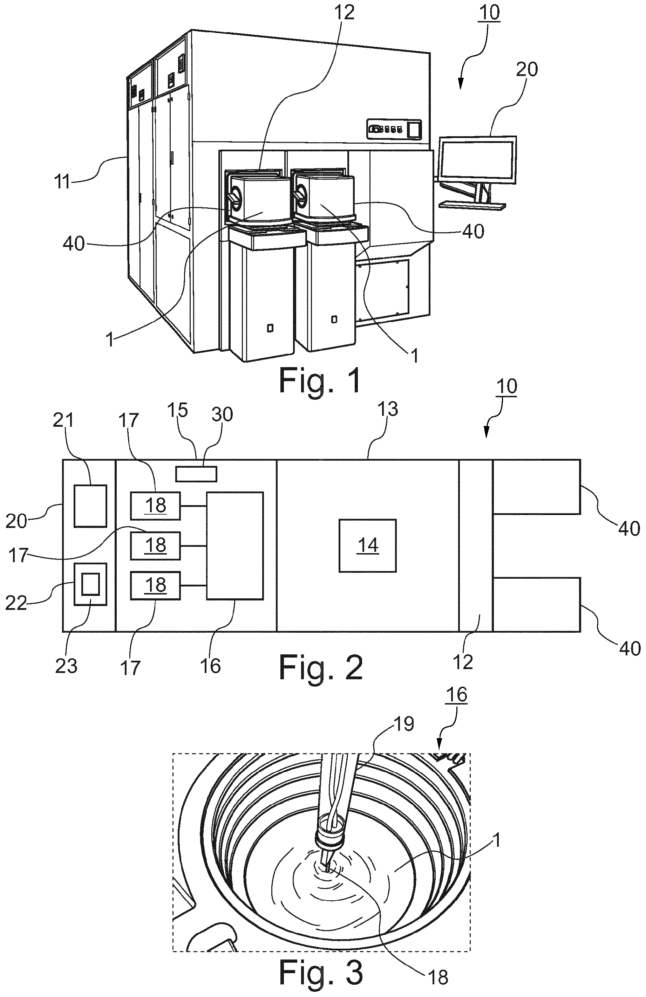

Figure 1 shows a perspective view of a wet etching processing system 10 or, in other words, a system for carrying out a wet etching process 10 according to an example. The wet etching processing system 10 of this example comprises a housing 11 and an obtaining section 12 for obtaining specimens 1, in this exemplary case semiconductor wafers 1 (see Fig. 3).

As shown in Fig. 1, the wafers 1 may be obtained from respective containers 40 containing the wafers 1 (as indicated in Fig. 1). Merely as an example, two containers 40 are shown herein, however, the number of containers 40 may be less or more. For example, one or more of the containers 40 may be containing the wafers 1, which have not yet been processed by the system 10, in particular not have been wet etched, and one or more other containers 40 may be obtaining or receiving the wafers 1 after their processing or wet etching by the system 10.

Additionally, the system 10 comprises a data processing system 20, herein shown exemplary with a monitor and interface for receiving input from a human operator. The data processing system 20 is exemplary shown outside of the housing 11 but may be alternatively positioned also inside the housing 11 and without the monitor and interface, for example.

Figure 2 shows the wet etching processing system 10 in a schematic illustration. Generally, any system, section and similar as shown in system 10 is merely shown herein in position, size and number only schematically and can be located, sized or in number different than shown. The wafers 1 to be etched are received from one or more of the shown containers 40 through the obtaining section 12, e.g., an opening inside the housing 11, and in particular by a handling section 13. The handling section 13 may comprise one or more handling means 14, such as one, two or more robotic arms, for example, for handling the wafers 1. In particular, the handling means 14 may provide the wafers 1 to be etched to a processing section 15, in which a chamber 16 or device may be located for etching the wafers 1. In particular, there may be several processing sections 15 and/or chambers 16 or devices. For example, the wafers 1 may be parallelly processed by the respective sections 15 and/or chambers 16. Similarly, the one or more handling means 14 may receive the wafers 1 again once they have been etched and provide them inside of the one or more other containers 40 for receiving the processed wafers 1.

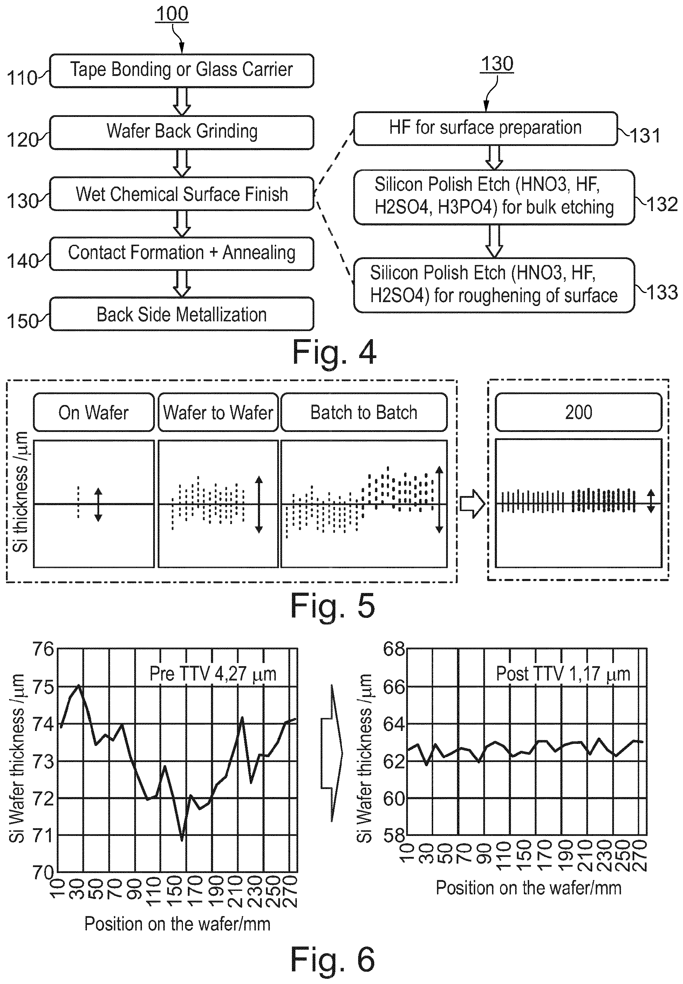

The chamber 16 or device may be supplied with chemical liquid 18 comprising one or more chemical etchants for etching the wafers 1. The chemical liquid 18 may be contained inside one or more containers 17 or, in other words, tanks for containing the chemical liquid 18. The containers 17 may for example be in the range of one to four. The containers 17 may be located inside the system 10, in particular the housing 11, or externally thereof, for example, and connected to the system 10, e.g., via hoses. The chemical liquid 18 may also be herein referred to as a bath or bath of chemical liquid 18. In particular, different chemical liquid compositions may be provided inside of two or, as exemplary shown, three or more containers 17 for different chemical etching processes 131, 132, 133 as exemplary explained hereinafter with reference to Fig. 4.

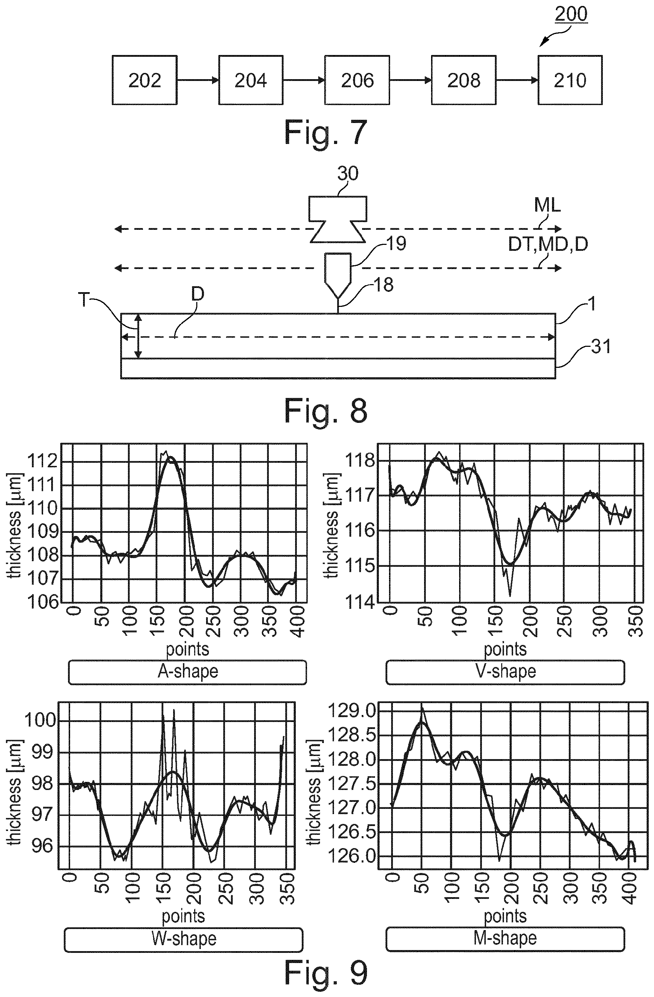

The wet etching processing system 10, e.g., in the processing section 15, may further comprise one or more measurement systems 30, which may comprise one or more sensor units, including one or more, spectrometers, camera units and/or line scanners, for obtaining measurement data indicative of a thickness of one or more of the wafers 1 along at least parts of a measurement line ML (see Fig. 8) before and/or after being etched by the chemical liquid(s) 18 after one, more or each one of the wet etching processes 131, 132, 133. In this exemplary case, the measurement system 30 may comprise an FTIR spectrometer emitting and moving a measurement beam along the measurement line ML.

Further, as shown in Fig. 2, the data processing system 20 may comprise a data processing apparatus 21, e.g., in the form of one or more computers or computing units. Moreover, the data processing system 20 may comprise a computer program product 22 in the form of a computer readable storage medium 22, on which a computer program product 23 in the form of a computer program 23 may be stored. When the data processing apparatus 21 carries out the instructions of the computer program 23, the method 200 as shown in Fig. 7 and will be explained hereinafter may be executed.

Figure 3 shows a perspective view of the processing chamber 16 of the wet etching processing system 10. In this example, the wet etching is shown as a single wafer etching process, in which single wafers 1 are consecutively etched by dispensing the chemical liquid 18 onto their surface. In this example, the chemical liquid 18 is delivered, e.g., pumped, to a dispensing unit 19, e.g., in the form of a nozzle, dispensing the chemical liquid 18 onto a surface, in particular frontside, of the wafer 1 provided inside the processing chamber 16. Exemplary, the dispensing unit 19 is shown as a single nozzle with a single outlet or dispensing port, however, alternatively, there may be more nozzles or more outlets or ports on the nozzle. A feed line, pump and/or similar may be provided inside the processing section 15 and connecting the containers 17 with the chamber 16, in particular the dispensing unit 19 therein. Also, there may be a drain line provided at the containers 17 for draining the chemical liquid 18 therefrom. For example, the wafer 1 may be rotated during the dispensing of the chemical liquid 18 by a rotation unit 31 (see Fig. 8), which may, for example, be disposed underneath the wafer 1 and driven by an actuator, e.g., an electric motor. For example, the rotation unit 31 may comprise a chuck or similar, on which the wafer 1 is disposed, e.g., attached, affixed, or bonded thereto. Moreover, as may be seen from Fig. 3, the wafer 1 may be elevated to different levels or drain sections of the processing chamber 16, e.g., for consecutive wet etching with the different chemical liquids 18, e.g., also by an actuator such as an electric motor or the same actuator.

Figure 4 schematically illustrates a backend-of-the-line (BEOL) process 100 of a semiconductor manufacturing process. In the exemplary shown BEOL process for power semiconductor devices employing the wafer 1, the wet etching may be used for wet chemical surface finishing 130 of the wafers 1. Typically, tape bonding or using a glass carrier wafer 110 and wafer back grinding 110 are preceding the wet etching surface finishing 130. Contact formation and annealing 140 and back side metallization 150 may follow the wet etching during the typical BEOL process 100 of semiconductor manufacturing.

Further, as shown for the wet chemical surface finishing 130, for example, three different etching processes 131, 132, 133 may be conducted consecutively, wherein each one of the three different chemical liquids 18 as shown in Fig. 2 may be used, thereby differentiating the wet etching processes 131, 132, 133 from one another. For example, a first wet etching process 131 may be used for preparation of the surface of the wafer 1 to be etched. For example, for this wet etching process, HF may be used as chemical liquid 18. A second wet etching process 132 may be used for polish etching of the surfaced of the wafer 1. Here, for example, a different chemical liquid 18 (in terms of its composition), e.g., containing HNO3, HF, H2SO4 and H3PO4, may be used. A third wet etching process 133 may be used for rough etching of the surface of the wafer 1. Here, again, a different chemical liquid 18 may be used, e.g., containing HNO3, HF, H2SO4. Hence, each wet etching process 131, 132, 133 processes the surface of the wafer 1 differently based on the used chemical liquid 18 or wet chemistry composition and can be attributed with the aforesaid intentions, i.e., surface preparation, polishing, and rough etching.

Figure 5 shows schematic illustrations of the typical thickness variation for a wafer 1, from wafer 1 to wafer 1, from batch to batch before chemical surface finishing 130, und a schematic illustration of the thickness variation for batch to batch if processed according to the method 200 of Fig. 7. The first illustration from the left shows the thickness variation as Silicon (Si) per µm on a single wafer 1. The second illustration from the left shows the thickness variation as Silicon (Si) per µm from wafer 1 to wafer 1 and for several wafers 1, which may be from the same batch. As becomes apparent, different wafers 1, even though from the same batch, may have significantly different thickness variations. The third illustration from the left shows the thickness variation as Silicon (Si) per µm from wafer 1 to wafer 1 and for two separate batches, the batch from the second illustration from the left being shown to the left and another batch with its thickness variations across its wafers 1 to the right next to it. Hence, the thickness of wafers 1 before the chemical surface finishing 130 may not only significantly fluctuate for wafers 1 of different batches, but also for the same batch.

The fourth illustration from the left in Fig. 5 shows the thickness variation of the wafers 1 of the different two batches of the third illustration after they are processed according to the method 200 of Fig. 7, which shows that the thickness variation is significantly reduced for all wafers 1 throughout both batches, resulting in an enhanced quality because the thickness variation is kept in a tight range compared to the third illustration and compared to typical chemical etching processing.

In Figure 6, the left graph shows the Si wafer thickness variation in µm relative to its position on the wafer 1 (specifically along a measurement line ML, see Fig. 8). The Pre TTV, i.e., the total thickness variation before the chemical surface finishing 130, can be calculated as 4,27 µm in this example. Specifically, the thickness varies along the measurement line ML between approximately 71 and approximately 75 µm. The right graph shows the Si wafer thickness variation in µm relative to its position on the wafer 1 after the method 200 has been carried out. The Post TTV, i.e., the total thickness variation after the chemical surface finishing 130, can be calculated as 1,17 µm. Specifically, the thickness varies along the measurement line ML between approximately 63 and approximately 64 µm. Hence, the TTV after method 200 has been significantly reduced.

Figure 7 shows a schematic illustration of a method 200 for controlling any, multiple or all of the wet etching processes 131, 132, 133 of Fig. **4****.**

The method 200 carries out any one or multiple of the wet etching processes 131, 132, 133 on the specimen surface of the specimen 1 as shown in Figs. 4 and 8, wherein Figure 8 is a schematic cross-section through the setup of the processing chamber 16 of Fig. 4. In this example, the wafer 1 is disc-shaped and has a thickness T and a diameter D. The thickness T varies along the diameter D based on the previous processing steps 110, 120, for example, and environmental conditions, to which it has been subject, and other potential factors during manufacturing and similar.

In a first step 202 of method 200, a measurement and/or measurement data is obtained, which is indicative of the thickness variation along the measurement line ML on the wafer 1 as shown in Fig. 8. This step may be in particular carried out by the measurement system 30. For example, the measurement beam of an FTIR spectrometer of the measurement system 30 may be moved along the measurement line ML, in particular in the form of a line scan. In this example, the measurement line ML is congruent to a diameter and dispensing trajectory of the dispensing unit 19, along which the dispensing unit 19 may be continuously moved for continuously dispensing the chemical liquid 18 onto the wafer surface.

In a second step 204 of method 200, thickness profile data may be obtained based on the measurement and/or the measurement data. The thickness profile data is indicative of a thickness profile of a thickness variation of the wafer 1 along the measurement line ML on the wafer surface prior to the wet etching process 131, 132, 133 carried out in step 208 of method 200. For example, the measurement system 30 may obtain the measurement data through measurement and forward it to the data processing system 20. At the data processing system 20, the thickness profile data may be obtained by receiving the measurement data and/or, optionally, processing the measurement data, in particular to determine the thickness variation of the wafer 1 along the measurement line ML.

Optionally, in any, before any or after any of steps 202, 204 of method 200, the method 200 may further comprise steps relating to the measurement system 30 as such, e.g., scanning the wafer 1, a fast Fourier transformation of measurement data, a peak detection, thickness raw value determination, and/or filtering of the measurement data, e.g., for removal of outliers and/or noise removal. The measurement data and/or the thickness profile data may be indicative of, comprise or be in the form of a wafer line scan map, for example.

In a third step 206 of method 200, based on the thickness profile data, control data for controlling one or more settings of the respective wet etching process 131, 132, 133, is obtained, in particular determined, by the data processing system 20. This means that the control data and/or the one or more settings are individually obtained or determined for each wafer 1 depending on its thickness profile. When the data processing system 20 executes the control data, the wet etching process 131, 132, 133 as carried out in step 208 may be controlled. The one or more settings may be representing a recipe to be used during the wet etching process 131, 132, 133. For example, the one or more settings or the recipe may be selected from predefined sets of settings or recipes or, for each wafer 1, determined based on the thickness profile data in every instance.

For determining the control data in step 206, the method 200 may comprise classifying a shape of the thickness profile into one of multiple different shapes of thickness variation, where each one of the multiple different shapes may be correlated with one or more settings for the wet etching process 131, 132, 133 to be carried out in step 208.

Such classification is exemplary shown in Fig. 9, where the shape of the thickness profile of a wafer 1 is classified into a shape of at least four different shape types, the at least four different shape types comprising a substantially A-shaped type, a substantially V-shaped type, a substantially W-shaped type, and a substantially M-shaped type.

Within step 206, after classifying the shapes of the thickness profiles, a classifying of one or more shape characteristics for the classified shape into one of multiple shape characteristics for the classified shape may follow, wherein the multiple different shape characteristics of thickness variation may be, in addition or alternatively to the multiple different shapes, correlated with one or more settings for the wet etching process 131, 132, 133 to be carried out in step 208.

Generally, the determination of the control data, in particular in terms of the classification, may be carried out at least partially by a machine learning algorithm, where the machine learning algorithm may be trained with the one or more settings of the control data from previous wet etching processes 131, 132, 132 and measurement data indicative of measured thickness variations along the measurement line ML of wafers 1 etched by the previous wet etching processes 131, 132, 133.

Specifically, in a step 210 of method 200, the wafer 1 that has been etched in step 208, may be measured once again by the measurement system 30 along the measurement line ML. For the step 208 itself, the dispensing unit 19 is continuously moved along at least part of the dispensing trajectory DT congruent with the measurement line ML and diameter D of the wafer 1 while continuously dispensing the chemical liquid 18 during the continuous movement of the dispensing unit 19. A dispensing profile being indicative of the dispensing time and the dispensing flow rate along the dispensing trajectory DT is an example of the settings or recipe, which may be included in the control data for use in step 208 of method 200.

The result of step 208 may be seen as explained with reference to Fig. 6 in the right graph, i.e., a significantly reduced TTV. The measurement data obtained thereby, in particular together with the control data used to achieve the result, may be fed back to the machine learning algorithm for training, thereby improving the correlation and thus the settings to be set depending on the thickness profile of each one of the wafers 1 that are being processed, wafer to wafer and batch to batch.

While the invention has been illustrated and described in detail in the drawings and foregoing description, such illustration and description are to be considered illustrative or exemplary and not restrictive; the invention is not limited to the disclosed embodiments.

As used herein, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Further, as used herein, the phrase "at least one" or similar, e.g., "one or more of", in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that such entities may optionally be present other than the entities specifically identified within the list of entities to which the phrase "at least one" or similar refers, whether related or unrelated to those entities specifically identified. Thus, as a non-limiting example, "at least one of A and B" (or, equivalently, "at least one of A or B" or, equivalently "at least one of A and/or B" or, equivalently "one or more of A and B", "one or more of A or B", or "one or more of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

As used herein, the phrase "being indicative of" may for example mean "reflecting" and/or "comprising". Accordingly, an entity, element and/or step referred to herein as "being indicative of [...]" can be synonymously or interchangeably used herein with one, two or all of said entity, element and/or step "comprising [...]" and said entity, element and/or step "reflecting [...]".

Further, as used herein, phrases such as "based on", "related" or "relating", "associated" and similar are not to be seen exclusively in terms of the entities, elements and/or steps to which they are referring, unless otherwise stated. Instead, these phrases are to be understood inclusively, unless otherwise stated, in that, for example, an entity, element or step referring by any of these phrases or similar, e.g., being "based on", an or another entity, element or step, does not exclude that the respective entity, element or step may be further or also "based on" any other entity, element or step than the one to which it refers.

The designation of methods and steps as first, second, etc. as provided herein is merely intended to make the methods and their steps referenceable and distinguishable from one another. By no means does the designation of methods and steps constitute a limitation of the scope of this disclosure. For example, when this disclosure describes a third step of a method, a first or second step of the method do not need to be present yet alone be performed before the third step unless they are explicitly referred to as being required per se or before the third step. Moreover, the presentation of methods or steps in a certain order is merely intended to facilitate one example of this disclosure and by no means constitutes a limitation of the scope of this disclosure. Generally, unless no explicitly required order is being mentioned, the methods and steps may be carried out in any feasible order. Specifically, the terms first, second, third or (a), (b), (c) and the like in the description and in the claims are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

In the context of the present invention any numerical value indicated is typically associated with an interval of accuracy that the person skilled in the art will understand to still ensure the technical effect of the feature in question. As used herein, the deviation from the indicated numerical value is in the range of ± 10%, and preferably of ± 5%. The aforementioned deviation from the indicated numerical interval of ± 10%, and preferably of ± 5% is also indicated by the terms "about" and "approximately" used herein with respect to a numerical value.

Any reference signs in the claims should not be construed as limiting the scope. The invention is defined by the appended claims.

## Claims

1. A method (200) for controlling a wet etching process (131, 132, 133), the wet etching process (131, 132, 133) using a dispensing unit (19) for dispensing a chemical liquid (18) containing a chemical etchant for etching a specimen surface of a specimen (1), and a rotation unit (31) for rotating the specimen (1),
wherein the dispensing unit (19) is continuously moved along a dispensing trajectory (DT) relative to the specimen (1) while the chemical liquid (18) is being dispensed onto the specimen surface and the specimen (1) is being rotated by the rotation unit (31),
the method (200) comprising:
- obtaining thickness profile data indicative of a thickness profile of a thickness variation of the specimen (1) along a measurement line (ML) on the specimen surface prior to the wet etching process (131, 132, 133); and
- obtaining control data for controlling one or more settings of the wet etching process (131, 132, 133) on the specimen surface based on the thickness profile data,
**characterized in that** the dispensing trajectory (DT) is congruent to the measurement line (ML).

2. The method (200) of claim 1,
wherein the obtaining of the thickness profile data is based on a measurement indicative of the thickness variation along the measurement line (ML) on the specimen (1), and comprises determining the thickness profile based on the measurement, and
wherein the control data is obtained by determining the one or more settings based on the determined thickness profile.

3. The method (200) of claim 1 or 2, wherein the specimen (1) is a wafer.

4. The method (200) of any one of the previous claims, wherein the chemical liquid (18) is being continuously dispensed by the dispensing unit (19) onto the specimen surface while the dispensing unit (19) is being continuously moved along the dispensing trajectory (DT) relative to the specimen (1).

5. The method (200) of any one of the previous claims, wherein the dispensing trajectory (DT) and/or the measurement line (ML) are traversing a center of the specimen surface.

6. The method (200) of any one of the previous claims, wherein at least one of the one or more settings relates to one or more of:
a dispensing time for dispensing the chemical liquid (18) by the dispensing unit (19),
a dispensing flow rate of chemical liquid (18) out of the dispensing unit (19),
a dispensing profile for dispensing the chemical liquid (18) by the dispensing unit (19), the dispensing profile being indicative of a dispensing time and/or dispensing flow rate along the dispensing trajectory (DT),
a rotation speed of the rotation unit (31),
a temperature of the chemical liquid (18),
a selection of a chemical liquid (18) from different chemical liquids (18) contained in different containers (17),
a change of composition of the chemical liquid (18) used by the dispensing unit (19),
a pressure of a gas stream around at least parts of the specimen (1), and
a selection of one or more dispensing ports from two or more dispensing ports of the dispensing unit (19).

7. The method (200) of any one of the previous claims, wherein the obtaining of the control data comprises:
- classifying a shape and/or one or more shape characteristics of the thickness profile into one of multiple different shapes and/or multiple different shape characteristics of thickness variation, each one of the multiple different shapes and/or multiple different shape characteristics of thickness variation being correlated with one or more settings for a wet etching process (131, 132, 133) of the specimen (1),
- determining the one or more settings based on the classified shape and/or classified one or more shape characteristics.

8. The method (200) of claim 7, wherein the method (200) comprises classifying the shape of the thickness profile first and consequently classifying the one or more shape characteristics for the classified shape into one of multiple shape characteristics for the classified shape.

9. The method (200) of claim 7 or 8, wherein the shape of the thickness profile is classified into a shape of at least four different shape types, the at least four different shape types comprising a substantially A-shaped type, a substantially V-shaped type, a substantially W-shaped type, and a substantially M-shaped type.

10. The method (200) of any one of claims 7 to 9, wherein the classification is carried out at least partially by a machine learning algorithm.

11. The method (200) of claim 10, the machine learning algorithm being trained with the one or more settings of the control data from previous wet etching processes and/or measurement data indicative of measured thickness variations along the measurement line (ML) of specimens (1) etched by the previous wet etching processes (131, 132, 133).

12. A computer program product (22, 23), which, when executed by a data processing system (20), instructs the data processing system (20) to carry out the method (200) according to any one of the previous claims.

13. A data processing system (20) configured to carry out the method (200) according to any one of claims 1 to 11.

14. A system (10) for carrying out a wet etching process (131, 132, 133), the system (10) comprising the data processing system (20) of claim 13, a container (17) for containing the chemical liquid (18), the dispensing unit (19) fluidically connected to the container (17) for dispensing the chemical liquid (18) from the container (17) onto the specimen surface, and the rotation unit (31) for rotating the specimen (1).

## Patentansprüche

1. Verfahren (200) zur Steuerung eines Nassätzprozesses (131, 132, 133), wobei der Nassätzprozess (131, 132, 133) unter Verwendung einer Abgabeeinheit (19) zum Abgeben einer chemischen Flüssigkeit (18), die ein chemisches Ätzmittel zum Ätzen einer Probenoberfläche einer Probe (1) enthält, und einer Dreheinheit (31) zum Drehen der Probe (1),
wobei die Abgabeeinheit (19) kontinuierlich entlang einer Abgabebahn (DT) relativ zur Probe (1) bewegt wird, während die chemische Flüssigkeit (18) auf die Probenoberfläche abgegeben wird und die Probe (1) durch die Dreheinheit (31) gedreht wird,
wobei das Verfahren (200) umfasst:
- Erfassen von Dickenprofildaten, die ein Dickenprofil einer Dickenvariation der Probe (1) entlang einer Messlinie (ML) auf der Probenoberfläche vor dem Nassätzprozess (131, 132, 133) angeben; und
- Ermitteln von Steuerdaten zur Steuerung einer oder mehrerer Einstellungen des Nassätzprozesses (131, 132, 133) auf der Probenoberfläche auf der Grundlage der Dickenprofildaten,
**dadurch gekennzeichnet, dass** die Abgabebahn (DT) mit der Messlinie (ML) kongruent ist.

2. Verfahren (200) nach Anspruch 1,
wobei das Ermitteln der Dickenprofildaten auf einer Messung basiert, die die Dickenvariation entlang der Messlinie (ML) auf der Probe (1) angibt, und das Bestimmen des Dickenprofils auf der Grundlage der Messung umfasst, und
wobei die Steuerdaten durch Bestimmen der einen oder mehreren Einstellungen auf der Grundlage des ermittelten Dickenprofils gewonnen werden.

3. Verfahren (200) nach Anspruch 1 oder 2, wobei die Probe (1) ein Wafer ist.

4. Verfahren (200) nach einem der vorstehenden Ansprüche, wobei die chemische Flüssigkeit (18) von der Abgabeeinheit (19) kontinuierlich auf die Probenoberfläche abgegeben wird, während die Abgabeeinheit (19) relativ zur Probe (1) kontinuierlich entlang der Abgabebahn (DT) bewegt wird.

5. Verfahren (200) nach einem der vorstehenden Ansprüche, wobei die Abgabebahn (DT) und/oder die Messlinie (ML) durch eine Mitte der Probenoberfläche verlaufen.

6. Verfahren (200) nach einem der vorstehenden Ansprüche, wobei sich mindestens eine der einen oder mehreren Einstellungen auf eine oder mehrere der folgenden Größen bezieht:
einer Dosierzeit zum Dosieren der chemischen Flüssigkeit (18) durch die Abgabeeinheit (19),
eine Abgabedurchflussrate der chemischen Flüssigkeit (18) aus der Abgabeeinheit (19),
ein Abgabeprofil für die Abgabe der chemischen Flüssigkeit (18) durch die Abgabeeinheit (19), wobei das Abgabeprofil eine Abgabezeit und/oder eine Abgabedurchflussrate entlang der Abgabebahn (DT) angibt,
eine Drehzahl der Dreheinheit (31),
eine Temperatur der chemischen Flüssigkeit (18),
eine Auswahl einer chemischen Flüssigkeit (18) aus verschiedenen chemischen Flüssigkeiten (18), die in verschiedenen Behältern (17) enthalten sind,
eine Änderung der Zusammensetzung der von der Abgabeeinheit (19) verwendeten chemischen Flüssigkeit (18),
einen Druck eines Gasstroms um zumindest Teile der Probe (1) herum und
eine Auswahl einer oder mehrerer Abgabestellen aus zwei oder mehr Abgabestellen der Abgabeeinheit (19).

7. Verfahren (200) nach einem der vorstehenden Ansprüche, wobei das Ermitteln der Steuerdaten umfasst:
- Klassifizieren einer Form und/oder eines oder mehrerer Formmerkmale des Dickenprofils in eine von mehreren verschiedenen Formen und/oder mehreren verschiedenen Formmerkmalen der Dickenvariation, wobei jede der mehreren verschiedenen Formen und/oder jedes der mehreren verschiedenen Formmerkmale der Dickenvariation mit einer oder mehreren Einstellungen für einen Nassätzprozess (131, 132, 133) der Probe (1) korreliert ist,
- Bestimmen der einen oder mehreren Einstellungen auf der Grundlage der klassifizierten Form und/oder der klassifizierten einen oder mehreren Formmerkmale.

8. Verfahren (200) nach Anspruch 7, wobei das Verfahren (200) umfasst, die Form des Dickenprofils zuerst zu klassifizieren und anschließend das eine oder die mehreren Formmerkmale für die klassifizierte Form in eines von mehreren Formmerkmalen für die klassifizierte Form zu klassifizieren.

9. Verfahren (200) nach Anspruch 7 oder 8, wobei die Form des Dickenprofils in eine Form von mindestens vier verschiedenen Formtypen klassifiziert wird, wobei die mindestens vier verschiedenen Formtypen einen im Wesentlichen A-förmigen Typ, einen im Wesentlichen V-förmigen Typ, einen im Wesentlichen W-förmigen Typ und einen im Wesentlichen M-förmigen Typ umfassen.

10. Verfahren (200) nach einem der Ansprüche 7 bis 9, wobei die Klassifizierung zumindest teilweise durch einen Algorithmus für maschinelles Lernen durchgeführt wird.

11. Verfahren (200) nach Anspruch 10, wobei der Algorithmus für maschinelles Lernen mit einer oder mehreren Einstellungen der Steuerdaten aus früheren Nassätzprozessen und/oder Messdaten trainiert wird, die gemessene Dickenabweichungen entlang der Messlinie (ML) von Proben (1) anzeigen, die durch die früheren Nassätzprozesse (131, 132, 133) geätzt wurden.

12. Computerprogrammprodukt (22, 23), das, wenn es von einem Datenverarbeitungssystem (20) ausgeführt wird, das Datenverarbeitungssystem (20) anweist, das Verfahren (200) gemäß einem der vorstehenden Ansprüche durchzuführen.

13. Datenverarbeitungssystem (20), das so konfiguriert ist, dass es das Verfahren (200) gemäß einem der Ansprüche 1 bis 11 ausführt.

14. System (10) zur Durchführung eines Nassätzprozesses (131, 132, 133), wobei das System (10) das Datenverarbeitungssystem (20) nach Anspruch 13, einen Behälter (17) zur Aufnahme der chemischen Flüssigkeit (18), die mit dem Behälter (17) fluidisch verbundene Abgabeeinheit (19) zum Abgeben der chemischen Flüssigkeit (18) aus dem Behälter (17) auf die Probenoberfläche und die Dreheinheit (31) zum Drehen der Probe (1) aufweist.

## Revendications

1. Procédé (200) pour contrôler un processus de gravure humide (131, 132, 133), le processus de gravure humide (131, 132, 133) utilisant une unité de distribution (19) pour distribuer un liquide chimique (18) contenant un agent de gravure chimique destiné à graver la surface d'un échantillon (1), et une unité de rotation (31) pour faire tourner l'échantillon (1),
dans lequel l'unité de distribution (19) est déplacée en continu le long d'une trajectoire de distribution (DT) par rapport à l'échantillon (1) tandis que le liquide chimique (18) est distribué sur la surface de l'échantillon et que l'échantillon (1) est mis en rotation par l'unité de rotation (31),
le procédé (200) comprenant :
- l'obtention de données de profil d'épaisseur indiquant un profil d'épaisseur d'une variation d'épaisseur de l'échantillon (1) le long d'une ligne de mesure (ML) sur la surface de l'échantillon avant le processus de gravure humide (131, 132, 133) ; et
- l'obtention de données de contrôle pour contrôler un ou plusieurs paramètres du processus de gravure humide (131, 132, 133) sur la surface de l'échantillon sur la base des données de profil d'épaisseur,
**caractérisé en ce que** la trajectoire de distribution (DT) est congruente avec la ligne de mesure (ML).

2. Procédé (200) selon la revendication 1,
dans lequel l'obtention des données de profil d'épaisseur est basée sur une mesure indicative de la variation d'épaisseur le long de la ligne de mesure (ML) sur l'échantillon (1), et comprend la détermination du profil d'épaisseur sur la base de la mesure, et
dans lequel les données de contrôle sont obtenues en déterminant le ou les réglages sur la base du profil d'épaisseur déterminé.

3. Procédé (200) selon la revendication 1 ou 2, dans lequel l'échantillon (1) est une plaquette.

4. Procédé (200) selon l'une quelconque des revendications précédentes, dans lequel le liquide chimique (18) est distribué en continu par l'unité de distribution (19) sur la surface de l'échantillon tandis que l'unité de distribution (19) est déplacée en continu le long de la trajectoire de distribution (DT) par rapport à l'échantillon (1).

5. Procédé (200) selon l'une quelconque des revendications précédentes, dans lequel la trajectoire de distribution (DT) et/ou la ligne de mesure (ML) traversent un centre de la surface de l'échantillon.

6. Procédé (200) selon l'une quelconque des revendications précédentes, dans lequel au moins l'un des un ou plusieurs réglages concerne un ou plusieurs des éléments suivants :
un temps de distribution pour distribuer le liquide chimique (18) par l'unité de distribution (19),
un débit de distribution du liquide chimique (18) sortant de l'unité de distribution (19),
un profil de distribution pour la distribution du liquide chimique (18) par l'unité de distribution (19), le profil de distribution indiquant une durée de distribution et/ou un débit de distribution le long de la trajectoire de distribution (DT) de l' ,
une vitesse de rotation de l'unité de rotation (31),
une température du liquide chimique (18),
une sélection d'un liquide chimique (18) parmi différents liquides chimiques (18) contenus dans différents récipients (17),
un changement de composition du liquide chimique (18) utilisé par l'unité de distribution (19),
une pression d'un flux gazeux autour d'au moins certaines parties de l'échantillon (1), et
la sélection d'un ou plusieurs orifices de distribution parmi deux ou plusieurs orifices de distribution de l'unité de distribution (19).

7. Procédé (200) selon l'une quelconque des revendications précédentes, dans lequel l'obtention des données de contrôle comprend :
- la classification d'une forme et/ou d'une ou plusieurs caractéristiques de forme du profil d'épaisseur en l'une parmi plusieurs formes différentes et/ou plusieurs caractéristiques de forme différentes de variation d'épaisseur, chacune desdites formes différentes et/ou caractéristiques de forme différentes de variation d'épaisseur étant corrélée à un ou plusieurs réglages pour un procédé de gravure humide (131, 132, 133) de l'échantillon (1),
- déterminer le ou les réglages sur la base de la forme classifiée et/ou de la ou des caractéristiques de forme classifiées.

8. Procédé (200) selon la revendication 7, dans lequel le procédé (200) comprend la classification de la forme du profil d'épaisseur en premier lieu, puis la classification de la ou des caractéristiques de forme pour la forme classée en l'une parmi plusieurs caractéristiques de forme pour la forme classée.

9. Procédé (200) selon la revendication 7 ou 8, dans lequel la forme du profil d'épaisseur est classée en une forme parmi au moins quatre types de formes différents, lesdits au moins quatre types de formes différents comprenant un type sensiblement en forme de A, un type sensiblement en forme de V, un type sensiblement en forme de W et un type sensiblement en forme de M.

10. Procédé (200) selon l'une quelconque des revendications 7 à 9, dans lequel la classification est effectuée au moins en partie par un algorithme d'apprentissage automatique.

11. Procédé (200) selon la revendication 10, l'algorithme d'apprentissage automatique étant entraîné avec le ou les réglages des données de contrôle provenant de processus de gravure humide antérieurs et/ou des données de mesure indiquant les variations d'épaisseur mesurées le long de la ligne de mesure (ML) d'échantillons (1) gravés par les processus de gravure humide antérieurs (131, 132, 133).

12. Un produit logiciel (22, 23) qui, lorsqu'il est exécuté par un système de traitement de données (20), ordonne à ce dernier de mettre en œuvre le procédé (200) selon l'une quelconque des revendications précédentes ( ).

13. Système de traitement de données (20) configuré pour mettre en œuvre le procédé (200) selon l'une quelconque des revendications 1 à 11.

14. Système (10) destiné à mettre en œuvre un procédé de gravure humide (131, 132, 133), le système (10) comprenant le système de traitement de données (20) de la revendication 13, un récipient (17) destiné à contenir le liquide chimique (18), l'unité de distribution (19) reliée de manière fluidique au récipient (17) pour distribuer le liquide chimique (18) depuis le récipient (17) sur la surface de l'échantillon, et l'unité de rotation (31) destinée à faire tourner l'échantillon (1).
